# EUROPEAN PATENT SPECIFICATION

(11) **EP 2 479 889 B1**
(45) Date of publication and mention of the grant of the patent: **19.03.2014**
(21) Application number: 11290028.7
(22) Date of filing: 19.01.2011
(51) Int. Cl.: H03F 1/32, H03F 3/72

(54) **Amplifier system and method of operating an amplifier system**
Verstärkersystem und Verfahren zum Betrieb eines Verstärkersystems
Système amplificateur et son procédé de fonctionnement

(43) Date of publication of application: 25.07.2012
(73) Proprietor: Alcatel Lucent, 75007 Paris (FR)
(72) Inventor: Yu, Xin, 70435 Stuttgart (DE); Bohn, Thomas, 70372 Stuttgart (DE); Machinal, Robin, 70197 Stuttgart (DE)
(74) Representative: Wetzel, Emmanuelle

(56) References cited:
- EP-A1- 0 905 919
- EP-A2- 0 410 399
- US-A- 4 028 634
- US-A- 5 371 479

## Description

### Field of the invention

The present invention relates to an amplifier system comprising a plurality of amplifier stages.

The present invention further relates to a method of operating an amplifier system comprising a plurality of amplifier stages.

### Background

Amplifier systems of the aforementioned type are usually employed within radio frequency (RF) transmission systems such as base transceiver stations of cellular communications networks. An input signal, which may e.g. comprise frequency components within the radio frequency range, is amplified by such amplifier systems, which enables to directly output the amplified signal to an antenna system for broadcast of the amplified signal via an air interface implemented by the antenna system.

Conventional amplifier systems, however, exhibit nonlinearities which are mainly due to nonlinear signal processing within the elements of the amplifier system. Apart from introducing undesired distortions to the amplified signal, the nonlinearities usually also lead to an effect denoted as "spectral regrowth", which means that a frequency spectrum of an amplified signal is increased due to the addition of further signal frequencies in the course of amplification.

To address the problem of nonlinearities, conventional amplifier systems already provide for linearization means which comprise a feedback loop for applying a predistortion to an input signal of the amplifier system, which depends on the output signal of said amplifier system. However, conventional linearization means require a comparatively large hardware effort and exhibit poor operational flexibility. Moreover, signal processing paths within said conventional feedback loop only carry predistorted signals which further reduces flexibility of such architectures.

Accordingly, there is a need to provide an improved amplifier system and an improved method of operating an amplifier system, which avoid the undesired effects of nonlinearities and spectral regrowth while at the same time exhibiting an increased operational flexibility.

### Summary

EP 0 905 919 A1 discloses non-linear amplifier calibration system and methods.

US 5,371,479 discloses a preamplifier with multi-stage feedback.

US 4,028,634 discloses a feed-forward amplifier with simple resistive coupling.

EP 0 410 399 A2 discloses a video preamplifier circuit that comprises two operational amplifiers an output of which is connected to multiplexer means. Input pads of the multiplexer means allow to select the output of which amplifier to take as an output signal for the multiplexer means.

### Summary

According to the present invention, regarding the amplifier system, this object is achieved by an amplifier system according to claim 1.

In other words, the inventive amplifier system comprises a plurality of amplifier stages, wherein each of said amplifier stages advantageously provides for a "local" (with reference to a specific amplifier stage) linearization, which is enabled by the linearizing means associated to each amplifier structure of the respective amplifier stage.

Thus, advantageously, it is possible to apply a linearization to the output signal of each amplifier stage, thus obtaining respective output signals of the amplifier stages which exhibit a low degree of distortions - if any. Moreover, in contrast to conventional amplifier systems, an output signal of an intermediate amplifier stage may also be employed for output to a further system, such as an antenna, since the local linearization, which is provided for by the linearizing means of each amplifier stage, ensures that an output signal of said intermediate stage already comprises a sufficient degree of linearity. This degree of flexibility is not possible with conventional systems having a plurality of amplifier in series configuration, since the conventional approach only provides for a global linearization by means of a global feedback loop.

Advantageously, said amplifier stages are connected in series to each other, which enables to provide a comparatively high overall signal amplification. For instance, a first number of amplifier stages according to the embodiments may be provided with preamplifier structures which comprise a comparatively low gain and a particularly high linearity. A last amplifier stage of the amplifier system according to the present embodiment may comprise a power amplifier which applies a further gain to the intermediate signal obtained by the chain of amplifier stages comprising said preamplifiers.

According to a further embodiment, said amplifier structure comprises a single amplifier or a chain of a plurality of amplifiers. I.e., an inventive amplifier stage may also comprise a plurality of amplifiers, which are connected in series to each other to form a chain of amplifiers. In this case, the inventive linearizing means are configured to linearize the output signal of the last amplifier of the chain of the respective amplifier stage thus again ensuring that an output signal of the respective amplifier stage satisfies predetermined linearity restrictions. On the other hand, multiple amplification is enabled by such an amplifier chain within a single amplifier stage, which offers the possibility to attain comparatively large overall gain factors for the amplifier system.

According to a further embodiment, said linearizing means are configured to receive a portion of an output signal of the associated amplifier structure and to modify an input signal for said amplifier structure, wherein said modification of the input signal usually comprises a characteristic which is inverse to the characteristic of distortion imparted to the signal to be amplified by the respective amplifier structure thus compensating nonlinearities. Alternatively, the linearizing means according to the embodiments may also be configured to modify the output signal of the amplifier structure depending on the input signal for the amplifier structure. In this case, which is also denoted as "post-linearization", the linearization is only effected after the output of the amplifier structure, i.e. by adding a signal component which - in combination with the distorted output signal of the amplifier structure - yields a basically non-distorted amplified signal that depends on the input signal fed to the amplifier structure.

According to the present invention, said amplifier system is configured to selectively connect an output terminal of the amplifier system to an output of one of said amplifier stages. Thus, an output signal of any of the involved amplifier stages may be "tapped" and fed to the global output terminal of the amplifier system, whereby intermediate overall gain factors may be achieved which depend on the position of the respective tapped amplifier stage within the chain of amplifier stages of said amplifier system.

In contrast to conventional amplifier systems, even with the aforementioned embodiment, output signals comprising comparatively few nonlinear distortions may be achieved, because each amplifier stage comprise an own linearizing configuration that enables a local linearization of the respective output signal of the amplifier stage.

According to a further embodiment, said amplifier system comprises multiplexer means which comprise a plurality of inputs, wherein at least two of said inputs can be connected to an output of a respective one of said amplifier stages, and a control unit which is configured to select one of said inputs of the multiplexer means for connection with an output of the multiplexer means, which in turn may be connected to the output terminal of the amplifier system. Thus, by appropriately controlling the multiplexer means, any of the intermediate output signals of the respective amplifier stages of the inventive amplifier system may be selected for output to the output terminal of the amplifier system. For instance, with a configuration which comprises a total number of n=3 amplifier stages, the aforementioned embodiment advantageously enables to selectively connect an output of the first, second or third amplifier stage to the output terminal of the amplifier system thus enabling to select three different output signals each of which has an aggregated gain which corresponds with the position of the respective amplifier stage in the overall configuration of three amplifier stages.

For instance, if the output terminal of the amplifier system is connected to the output of the first amplifier stage, the subsequent (presently two) amplifier stages are not required and may advantageously be deactivated or set to an energy saving mode, whereby an overall electrical efficiency of the amplifier system can be increased.

According to a further embodiment, a feedback loop is provided which couples back a portion of the output signal of said amplifier system to predistortion means that are configured to modify an input signal for the amplifier system depending on said portion of the output signal of said amplifier system. In contrast to the inventive local linearizing means, which are comprised within the different amplifier stages of the amplifier system, the present embodiment additionally provides for a "global" feedback loop which enables a signal feedback from the output of the last amplifier stage of the amplifier system to an input of the amplifier system, where digital predistortion means or the like may be provided for applying an additional predistortion to the input signal.

According to a further embodiment, instead of a global feedback loop, a local feedback loop of the linearizing means of the first amplifier stage may also be extended to the input of the amplifier system. I.e., a signal portion of an output signal of the first amplifier stage may be fed back to digital predistortion means which are provided at an input of the amplifier system for applying a digital predistortion to the input signal. In this case, the respective amplifier stage does not comprise a strict local linearization in the sense of the further embodiments, because the feedback loop is extended over the boundaries of the specific first amplifier stage, i.e. to the digital predistortion means at an input of the amplifier system.

A further solution to the object of the present invention is given by a method of operating an amplifier system according to claim 8. The inventive method proposes that an output signal of a first one of said amplifier stages is amplified by a second one of said amplifier stages.

Further advantageous embodiments are given by the dependent claims.

### Brief description of the figures

Further features, aspects and embodiments of the present invention are given in the following detailed description with reference to the drawings, in which:
- FIG. 1: depicts a simplified block diagram of a first embodiment of the amplifier system,
- FIG. 2a, 2b: depict simplified block diagrams of amplifier stages according to the embodiments,
- FIG. 3: depicts a further embodiment of an amplifier system according to the present invention,
- FIG. 4: depicts a simplified block diagram of a further embodiment of the inventive amplifier system which comprises a global feedback loop,
- FIG. 5: depicts a simplified block diagram of a further embodiment of the amplifier system wherein a feedback loop of a first amplifier stage is extended to digital predistortion means arranged at an input of the amplifier system,
- FIG. 6: depicts a simplified block diagram of a further embodiment of an amplifier stage,
- FIG. 7: depicts a simplified block diagram of a further embodiment of the amplifier system, and
- FIG. 8: depicts a simplified flowchart of a method according to the embodiments.

### Description of the embodiments

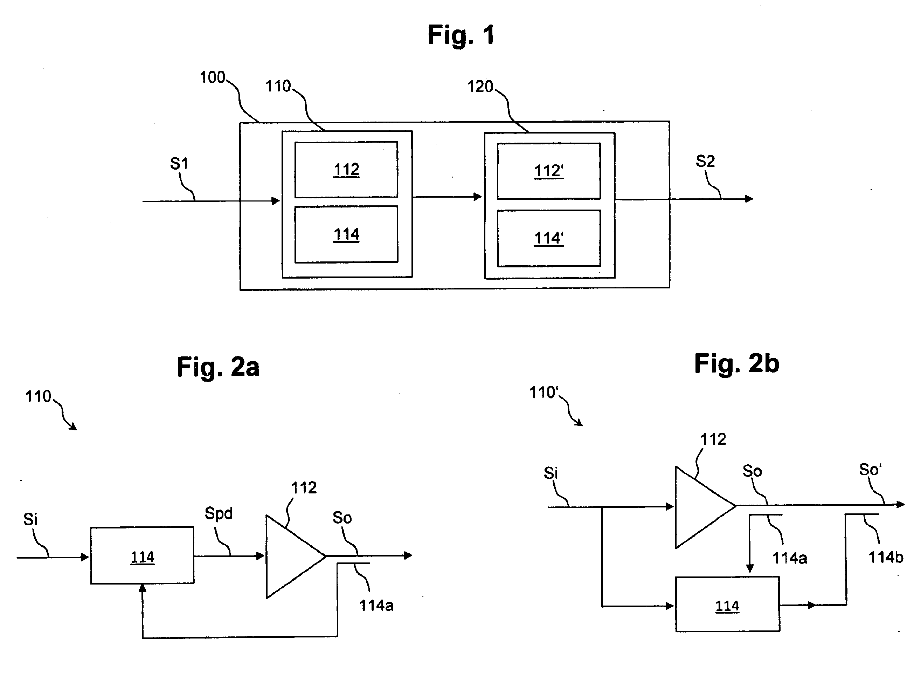

FIG. 1 depicts a simplified block diagram of an amplifier system 100 according to the embodiments.

The amplifier system 100 may e.g. be configured as an electrical amplifier for amplifying electrical input signals S1, which may e.g. comprise frequency components within a radio frequency, RF, range. However, the inventive principle is not limited to amplification of radio frequency signals. It may rather also be applied to the amplification of other electrical signals which are comprised in further frequency ranges.

The amplifier system 100 comprises a plurality of amplifier stages 110, 120 which, according to a preferred embodiment, are connected in series to each other. I.e., the first amplifier stage 110 depicted by FIG. 1 amplifies the input signal S1 provided to the amplifier system 100 and provides at its output an intermediate amplified signal, which is fed to an input to the subsequent second amplifier stage 120. Likewise, the second amplifier stage 120 amplifies the signal provided at its input port, and outputs a correspondingly amplified signal, which in the present case represents the output signal S2 of the amplifier system 100. The present invention is not limited to two amplifier stages 110, 120; the amplifier system 100 may rather comprise three or more amplifier stages, which usually depends on an overall gain to be provided for by the amplifier system 100.

The first amplifier stage 110 comprises an amplifier structure 112, which according to a preferred embodiment may be represented by an electrical amplifier. Moreover, the amplifier stage 110 comprises local linearizing means 114 which are associated with said at least one amplifier structure 112 and which are configured to linearize an output signal of said at least one amplifier structure 112 of its amplifier stage 110.

Likewise, the second amplifier stage 120 comprises an amplifier structure 112' and associated linearizing means 114', wherein a functionality of the components 112', 114' is identical with the afore described function of the elements 112, 114 of the first amplifier stage 110. As such, the second amplifier stage 120 comprises a functionality which is comparable with that of the first amplifier stage 110. The different amplifier stages 110, 120 may comprise a completely identical structure according to some embodiments. However, according to further embodiments, the different amplifier stages 110, 120 may also comprise different structures.

FIG. 2a depicts a simplified block diagram of a first embodiment of an amplifier stage 110. The amplifier stage 110 comprises a single amplifier 112. A portion of an output signal So of the amplifier 112 is coupled to a local feedback path by coupling means 114a, wherein said local feedback path provides the portion of the output signal So to an input of linearizing means 114 which are associated with said amplifier 112.

The linearizing means 114 also receive an input signal Si of the amplifier stage 110. When using the amplifier stage 110 depicted by Fig. 2a within the amplifier system of Fig. 1, for example, the input signal Si for the first amplifier stage 110 is equal to the signal S1. The linearizing means 114 are configured to modify the input signal Si (Fig. 2a) depending on the feedback signal portion of the output signal So in order to compensate any nonlinearities which may be imparted to the signal during amplification by the amplifier 112. As such, the linearizing means 114 provide at their output a predistorted signal Spd which depends on the input signal Si and the feedback portion of the output signal So. Usually, the linearizing means 114 will be configured to apply a transfer function to the feedback signal portion which is basically inverse to the transfer function related to the nonlinearities generated within the amplifier 112 for efficiently compensating said nonlinearities.

The amplifier 112 amplifies the predistorted signal Spd and outputs at its output the output signal So, which represents the output signal of the amplifier stage 110.

The amplifier stage depicted by FIG. 2a comprises the significant advantage of a local signal linearization. I.e., the output signal So of the amplifier 112 is linearized on a local basis, i.e. within the amplifier stage 110 without requiring external components for said linearization. As an advantage, at the output of the amplifier stage 110, an output signal So is provided which comprises only small amounts - if any - of nonlinearities.

Thus, subsequent amplifier stages such as e.g. the second amplifier stage 120 of the amplifier system 100 as depicted by FIG. 1 are provided with an input signal having a high degree of linearity, which leads to an increased overall signal quality with respect to the output signal S2 of the amplifier system 100.

Further amplifier stages such as the second amplifier stage 120 depicted by FIG. 1 may also comprise the structure explained above with respect to FIG. 2a.

FIG. 2b depicts a simplified block diagram of a further amplifier stage architecture 110' which may e.g. be employed within the amplifier stages 110, 120 of the amplifier system 100 according to FIG. 1.

In contrast to the amplifier stage architecture depicted by FIG. 2a, the architecture 110' depicted by FIG. 2b does not comprise a series arrangement of the components 114, 112. The amplifier stage architecture 110' of FIG. 2b rather provides for a "post-linearization" in that the linearizing means 114 do not provide a pre-distorted input signal to the amplifier 112. The linearizing means 114 rather provide an output signal which is added to an (usually distorted) output signal So of the amplifier 112 by means of the coupler 114b, which yields a linearized output signal So'. Thus, the distortions imparted on the input signal Si by the amplifier 112 in the course of signal amplification may be compensated by means of modifying the output signal So of the amplifier 112 by way of addition of the output signal of the linearizing means 114, which are added to the output signal So of the amplifier 112 at the coupler 114b.

The linearizing means 114 receive information on the output signal So by means of the further coupler 114a, which feeds back a portion of the output signal So to the linearizing means 114.

In a per se known manner, the linearizing means 114 of FIG. 2b generate a compensating output signal for addition to the output signal So of the amplifier 112 depending on the input signal Si and the feedback signal portion provided by the coupler 114a.

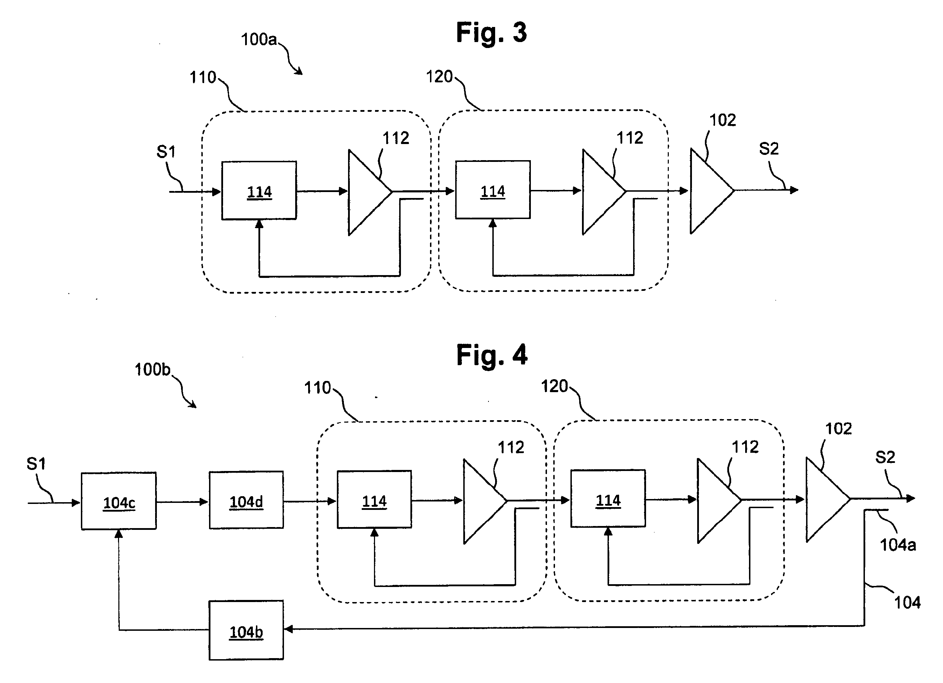

FIG. 3 depicts a further embodiment 100a of the inventive amplifier system. The amplifier system 100a comprises two amplifier stages 110, 120, wherein each amplifier stage has the same structure and functionality as explained for the amplifier stage 110 with reference to FIG. 2a.

Additionally, the amplifier system 100a of FIG. 3 comprises a further amplifier 102 which amplifies an output signal of the second amplifier stage 120.

According to a particularly preferred embodiment, the amplifier structures 112 of the first and second amplifier stage 110, 120 comprise amplifiers, which are configured to work as pre-amplifiers having a comparatively low nonlinearity. In contrast to the amplifiers 112 of the amplifier stages 110, 120, the further amplifier 102 is configured as a power amplifier.

An overall signal gain of the amplifier system 100a according to FIG. 3 thus depends on the configuration of the pre-amplifiers 112 and the power amplifier 102.

FIG. 4 depicts a further embodiment 100b of an amplifier system according to the present invention. In analogy to the embodiment explained above with reference to FIG. 3, the amplifier system 100b of FIG. 4 comprises a first amplifier stage 110 and a subsequent second amplifier stage 120, and a power amplifier 102 which provides further amplification of the output signal of the second amplifier stage 120.

In addition to the configuration according to FIG. 3, the amplifier system 100b of FIG. 4 comprises a global feedback path 104. The global feedback path 104 receives a portion of the output signal S2 as obtained at an output of the power amplified 102 by means of the coupler 104a. An analog to digital converter (ADC) 104b converts the signal portion transmitted via the feedback path 104 from the analog domain to the digital domain. After the ADC 104b, a respective digital feedback signal is provided to the digital predistortion means 104c, which also receive a digital input signal S1. The digital predistortion means 104c are configured to apply a digital predistortion to the input signal S1 depending on the feedback signal received from the feedback path 104 in order to compensate any nonlinearities which are introduced to the signal S1 during amplification within the various amplifier stages 110, 120 and the power amplifier 102. The feedback path 104 may thus also be considered as a global feedback path, in contrast to the local feedback mechanisms which are additionally provided within the amplifier stages 110, 120.

For example, the digital predistortion means 104c may comprise a calculation unit such as a microcontroller or a digital signal processor (DSP) or programmable logic components such as Field Programmable Gate Arrays (FPGA) or Application Specific Integrated Circuits (ASIC).

In addition to the inventive local linearization which is effected by the linearizing means 114 of the respective amplifier stages 110, 120, the amplifier system 100b according to FIG. 4 also provides for a global linearization mechanism employing the digital pre-distortion device 104c and the feedback path 104.

A predistorted digital input signal, which is obtained at an output of the digital pre-distortion device 104c, is converted to the analog domain by the digital to analog converter (DAC) 104d prior to forwarding it to the input of the first amplifier stage 110.

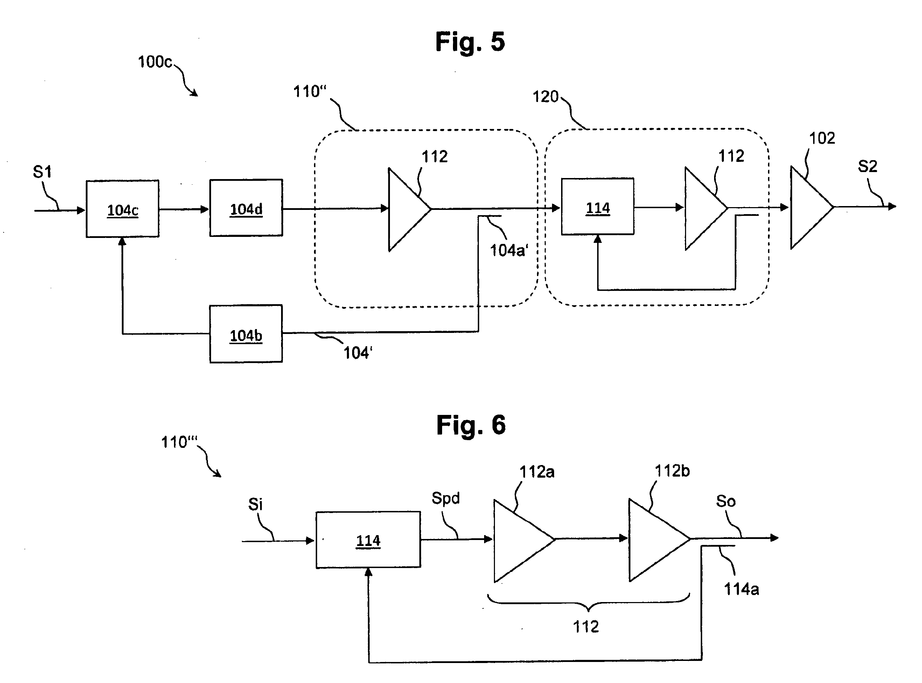

FIG. 5 depicts a simplified block diagram of a further amplifier system 100c according to the embodiments. The amplifier system 100c of FIG. 5 comprises two amplifier stages 110'', 120, wherein the second amplifier stage 120 is identical to the second amplifier stage 120 of FIG. 4 explained above.

However, the first amplifier stage 110'' of FIG. 5 does not provide a locally limited linearization, i.e. a process of linearization which is performed merely within the first amplifier stage 110''. The amplifier stage 110'' rather comprises a feedback loop 104' which extends from an output of the amplifier 112 to the digital predistortion means 104c which are arranged at an input of the amplifier system 100c. Thus, a portion of the output signal of the amplifier 112 of the first amplifier stage 110" is obtained by the coupler 104a' within the first amplifier stage 110'' and forwarded via the feedback path 104' to the ADC 104b. After conversion to the digital domain, a corresponding digital feedback signal is forwarded to the digital predistortion device 104c, where it is used for digitally predistorting the input signal S1.

FIG. 6 depicts a simplified block diagram of a further amplifier stage architecture 110''' according to the embodiments. In contrast to the amplifier architectures 110, 110' explained above with reference to FIG. 2a, 2b, the amplifier stage 110''' comprises an amplifier structure 112 which comprises more than one amplifier. In the present case, the amplifier structure 112 of the amplifier stage 110''' comprises two amplifiers 112a, 112b which are arranged in series and thus provide an increased overall gain while amplifying the pre-distorted input signal Spd.

However, in order to enable a local linearization within the amplifier structure 110''', a feedback path with an associated coupler 114a is provided which supplies the local linearizing means 114 of the amplifier stage 110''' with a respective feedback signal.

The amplifier structure 112 may also comprise more than two amplifiers.

Although not providing for a linearization of the intermediate output signals, i.e. the output signal of the first amplifier 112a of the amplifier structure 112, an output signal So of the amplifier stage 110''' comprises a comparatively low degree of nonlinearities - if any - due to the local linearization by means of linearizing means 114. I.e., as seen from outside the amplifier stage 110''', the stage 110''' also provides for a local linearization, although the various single amplifiers 112a, 112b are not linearized individually but rather together in their chain configuration.

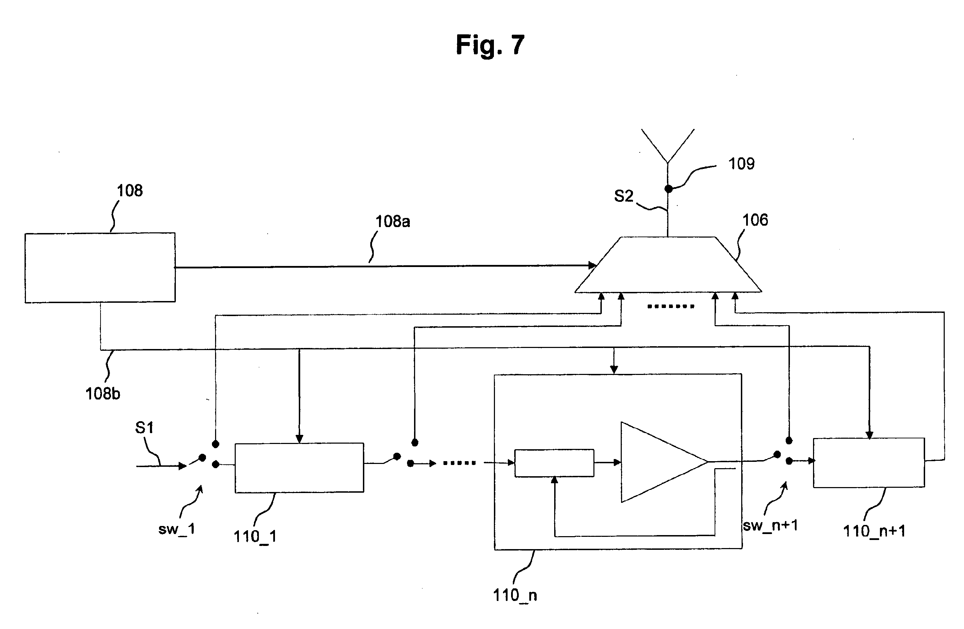

FIG. 7 depicts a further embodiment of an amplifier system according to the present invention.

A plurality of amplifier stages 110_1, ..., 110_n, 110_n+1 are provided which are connected to each other in a serial configuration thus forming an amplifier stage chain.

Multiplexer means 106 are provided which comprise a plurality of input ports, wherein preferably each input port of the multiplexer means 106 is connected to an output of one of the plurality of amplifier stages. Moreover, as an option, the input signal S1, which is supplied to the first amplifier stage 110_1, may also be connected to an input port of the multiplexer means 106, cf. switch sw_1, which enables to forward the input Signal S1 without any amplification directly to the multiplexer means 106 and an output terminal 109 connected to an output thereof. I.e., a first input of the multiplexer 106 can be connected to an input of the first amplifier stage 110_1 by a first switch sw_1. The switch sw_1 is preferably operated under control of a control unit 108 of the amplifier system, wherein a control bus 108b connects the control unit 108 with the amplifier stages 110_1, ...

A further input of the multiplexer 106 is e.g. connected to a further switch which is arranged at an output of the amplifier stage 110_1, and so on.

As can be seen from FIG. 7, yet another input of the multiplexer 106 can be connected to an output of the n-th amplifier stage 110_n by means of the switch sw_n+1, again under control of the control unit 108 via the control bus 108b.

Simultaneously, the control unit 108 controls the operation of the multiplexer means 106 via the control line 108a. Thus, the control unit 108 can control, which input of the multiplexer 106 is connected with an output port 109 of the multiplexer 106, which presently is connected to an antenna for broadcasting the amplified signal S2.

The configuration depicted by FIG. 7 advantageously enables to selectively put out one of the amplifier stages' output signals to the antenna at the output port 109. I.e., if an overall gain factor, which is smaller than the theoretical maximum gain factor achievable by the configuration According to FIG. 7, is desired, control unit 108 may control the multiplexer means 106 to e.g. connect an output of the first amplifier stage 110_1 with the output terminal 109 of the multiplexer thus forwarding the output signal S2 with a comparatively small gain factor to the antenna. The further amplifier stages of the amplifier system's amplifier chain may advantageously be deactivated in this case thus contributing to an increased operational efficiency of the amplifier system.

The deactivation of the further amplifier stages may also be controlled via the control bus 108b by the control unit 108.

However, if a maximum amplification is required for the output signal S2, the control unit 108 may control the multiplexer means 106 so as to connect that input of the multiplexer 106 with the output signal 109, which corresponds with the output of the highest amplifier stage 110_n+1, whereby the aggregated gain factor of the whole amplifier chain (amplifier stages 110, ..., 110_n+1) is used.

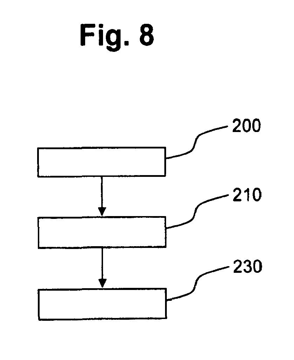

FIG. 8 depicts a simplified flowchart of a method according to the embodiments. In a first step 200, the control unit 108 determines which gain factor is to be applied to the input signal S1 (FIG. 7) and evaluates an amplifier stage which provides at its output a correspondingly amplified signal. In a second step 210 (FIG. 8), the control unit 108 connects an output of the respective amplifier stage 110_1 with the output terminal 109 of the multiplexer means 106 (FIG: 7).

In the subsequent step 230, the correspondingly amplified output signal S2 is forwarded via the output terminal 109 to the antenna. The remaining power amplifier stages after the last used power amplifier stage would be powered off.

According to a further preferred embodiment, the linearizing means 114 (FIG. 1) operate in the analog domain, i.e. they receive an analog input signal Si (FIG. 2a) and an analog feedback signal, which represents a portion of the analog amplified output signal So, and they output an analog predistorted signal Spd.

However, an internal processing, i.e. linearization processing, may also be performed within the digital domain, wherein respective ADC and DAC conversions have to be performed within the linearizing means 114 of the respective amplifier stage.

The embodiments advantageously provide the possibility to design pre-amplifier (driver) architectures with highly efficient PA (power amplifier) concepts. Therefore, the overall efficiency of entire PA chains can be sigificantly improved.

Moreover, due to improved linearity, in some configurations, the principle according to the embodiments may advantageously enable to decrease the number of amplifier stages while still achieving a sufficient overall gain.

Still further, from the architecture point of view, the embodiments of the present invention are backwards compatible to existing systems.

As with the approach of the present embodiments, a chain of subsequent individually linearized amplifier (structures) is obtained, the adaptability of RF transceivers to different power classes is easier. Furthermore the linearization of each amplifier 112 it totally independent of a linearization of an amplifier of another amplifier stage. Therefore, the stability of the whole PA chain is improved.

Based on the present embodiments, one can even imagine building integrated linearized PAs (power amplifiers) as hybrid devices consisting of analogue linearizer means 114 and PA devices.

The proposed new PA concept as explained with reference to Fig. 7 provides the possibility to easily construct a PA system with arbitrary gain by serial connection of several sub-stages 110_1, .., 110_n+1. In real time, one can switch the amplifier system's output 109 between the sub-stages 110_1, .., 110_n+1 according to different load situation. The unused sub-stages can be turned off for the purpose of saving energy. Therefore, the inventive PA concept has a particularly high energy efficiency even for different load situations.

The amplifier system according to the embodiments may advantageously be employed without a global feedback loop for predistortion due to its local linearization, cf. Fig. 1, Fig. 3. However, according to further embodiments, additionally, a global feedback loop may also be provided, cf. Fig. 4.

The description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Amplifier system (100) comprising a plurality of amplifier stages (110, 120), wherein each amplifier stage (110, 120) comprises at least one amplifier structure (112) and linearizing means (114) which are associated with said at least one amplifier structure (112) and which are configured to linearize an output signal (So) of said at least one amplifier structure (112) of said amplifier stage (110, 120), wherein said amplifier stages (110, 120) are connected in series to each other, and wherein said amplifier system (100) is configured to selectively connect an output terminal (109) of said amplifier system (100) to an output of one of said amplifier stages (110, 120) and to deactivate or set to an energy saving mode subsequent amplifier stages.

2. Amplifier system (100) according to one of the preceding claims, wherein said at least one amplifier structure (112) comprises a single amplifier (112a) or a chain of a plurality of amplifiers (112a, 112b).

3. Amplifier system (100) according to one of the preceding claims, wherein said linearizing means (114) are configured to receive a portion of an output signal (So) of the associated amplifier structure (112) and to modify an input signal (Si) for said amplifier structure (112) or said output signal (So) depending on said input signal (Si).

4. Amplifier system (100) according to one of the preceding claims, wherein a control unit (108) is provided which is configured to control a deactivation of said subsequent amplifier stages.

5. Amplifier system (100) according to claim 1, wherein said amplifier system (100) comprises multiplexer means (106) which comprise a plurality of inputs, wherein at least two of said inputs are connected to an output of a respective one of said amplifier stages (110, 120), and a control unit (108) which is configured to select one of said inputs of the multiplexer means (106) for connection with an output of the multiplexer means (106).

6. Amplifier system (100) according to one of the preceding claims, wherein a feedback loop (104) is provided which couples back a portion of the output signal (S2) of said amplifier system (100) to predistortion means (104c) that are configured to modify an input signal (S1) for the amplifier system (100) depending on said portion of the output signal (S2) of said amplifier system (100).

7. Method of operating an amplifier system (100) comprising a plurality of amplifier stages (110, 120), wherein each amplifier stage (110) comprises at least one amplifier structure (112) and linearizing means (114) which are associated with said at least one amplifier structure (112) and which are configured to linearize an output signal (So) of said at least one amplifier structure (112) of said amplifier stage (110, 120), wherein an output signal of a first one of said amplifier stages (110, 120) is amplified by a second one of said amplifier stages (110, 120), wherein said amplifier stages (110, 120) are connected in series to each other, and wherein said amplifier system (100) selectively connects an output terminal (109) of said amplifier system (100) to an output of one of said amplifier stages (110, 120) and deactivates or sets to an energy saving mode subsequent amplifier stages.

8. Method according to claim 7, wherein said at least one amplifier structure (112) amplifies an input signal by means of a single amplifier (112a) or a chain of a plurality of amplifiers (112a, 112b).

9. Method according to one of the claims 7 to 8, wherein said linearizing means (114) receive a portion of an output signal (So) of its associated amplifier structure (112) and modify an input signal (Si) for said amplifier structure (112) or said output signal (So) depending on said input signal (Si).

10. Method according to claim 7, wherein said amplifier system (100) comprises multiplexer means (106) which comprise a plurality of inputs, wherein at least two of said inputs are connected to an output of a respective one of said amplifier stages (110_1, .., 110_n, 110_n+1), and wherein a control unit (108) selects one of said inputs of the multiplexer means (106) for connection with an output of the multiplexer means (106).

11. Method according to one of the claims 7 to 10, wherein a feedback loop (104) is provided which couples back a portion of the output signal (S2) of said amplifier system (100) to predistortion means (104c) which modify an input signal (S1) for the amplifier system (100) depending on said portion of the output signal (S2) of said amplifier system (100).

## Patentansprüche

1. Verstärkersystem (100) mit einer Vielzahl von Verstärkerstufen (110, 120), wobei jede Verstärkerstufe (11, 120) mindestens eine Verstärkerstruktur (112) sowie Linearisierungsmittel (114) umfasst, welche mit der besagten mindestens einen Verstärkerstruktur (112) assoziiert und für die Linearisierung eines Ausgangssignals (So) der besagten mindestens einen Verstärkerstruktur (112) der besagten Verstärkerstufe (110, 120) konfiguriert sind, wobei die besagten Verstärkerstufen (110, 120) in Reihe zueinander geschaltet sind, und wobei das besagte Verstärkersystem (100) für den selektiven Anschluss eines Ausgabeterminals (109) des besagten Verstärkersystems (100) an einen Ausgang einer der besagten Verstärkerstufen (110, 120) und für die Deaktivierung oder das Versetzen in einen Energiesparmodus von aufeinanderfolgenden Verstärkerstufen konfiguriert ist.

2. Verstärkersystem (100) nach einem der vorstehenden Ansprüche, wobei die besagte mindestens eine Verstärkerstruktur (112) einen einzelnen Verstärker (112a) oder eine Kette mit mehreren Verstärkern (112a), 112b) umfasst.

3. Verstärkersystem (100) nach einem der vorstehenden Ansprüche, wobei die Linearisierungsmittel (114) für den Empfang eines Abschnitts eines Ausgangssignals (So) der assoziierten Verstärkerstruktur (112) und das Modifizieren eines Eingangssignals (Si) für die besagte Verstärkerstruktur (112) oder des besagten Ausgangssignals (So) in Abhängigkeit von dem besagten Eingangssignal (Si) konfiguriert sind.

4. Verstärkersystem (100) nach einem der vorstehenden Ansprüche, wobei eine Steuerungseinheit vorgesehen ist, welche für die Steuerung einer Deaktivierung der besagten aufeinanderfolgenden Verstärkerstufen konfiguriert ist.

5. Verstärkersystem (100) nach Anspruch 1, wobei das besagte Verstärkersystem (100) Multiplexermittel (106) mit einer Vielzahl von Eingängen, wobei mindestens zwei der besagten Eingänge an einen Ausgang einer entsprechenden der besagten Verstärkerstufen (110, 120) angeschlossen sind, und eine Steuereinheit (108), welche für das Auswählen eines der besagten Eingänge der Multiplexermittel (106) für den Anschluss an einen Ausgang der Multiplexermittel (106) konfiguriert ist, umfasst.

6. Verstärkermittel (100) nach einem der vorstehenden Ansprüche, wobei eine Rückkopplungsschleife (104) vorgesehen ist, welche einen Abschnitt des Ausgangssignals (S2) des besagten Verstärkersystems (100) an Vorverzerrungsmittel (104c), welche für das Modifizieren eines Eingangssignals (S1) für das Verstärkersystem (100) in Abhängigkeit von dem besagten Abschnitt des Ausgangssignals (S2) des besagten Verstärkersystems (100) konfiguriert sind, zurückkoppelt.

7. Verfahren zum Betreiben eines Verstärkersystems (100) mit einer Vielzahl von Verstärkerstufen (110, 120), wobei jede Verstärkerstufe (110) mindestens eine Verstärkerstruktur (112) sowie Linearisierungsmittel (114) umfasst, welche mit der besagten mindestens einen Verstärkerstruktur (112) assoziiert und für die Linearisierung eines Ausgangssignals (So) der besagten mindestens einen Verstärkerstruktur (112) der besagten Verstärkerstufe (110, 120) konfiguriert sind, wobei ein Ausgangssignal einer ersten der besagten Verstärkerstufen (110, 120) durch eine zweite der besagten Verstärkerstufen (110, 120) verstärkt wird, wobei die besagten Verstärkerstufen (110, 120) in Reihe zueinander geschaltet sind, und wobei das besagte Verstärkersystem (100) einen Ausgabeterminal (109) des besagten Verstärkersystems (100) selektiv an einen Ausgang einer der besagten Verstärkerstufen (110, 120) anschließt und aufeinanderfolgende Verstärkerstufen deaktiviert oder in einen Energiesparmodus versetzt.

8. Verfahren nach Anspruch 7, wobei die besagte mindestens eine Verstärkerstruktur (112) mittels eines einzelnen Verstärkers (112a) oder einer Kette mehrerer Verstärker (112a, 112b) ein Eingangssignal verstärkt.

9. Verfahren nach einem der Ansprüche 7 bis 8, wobei die besagten Linearisierungsmittel (114) einen Abschnitt eines Ausgangssignals (So) seiner assoziierten Verstärkerstruktur (112) empfangen und ein Eingangssignal (Si) für die besagte Verstärkerstruktur (112) oder das besagte Ausgangssignal (So) in Abhängigkeit von dem besagten Eingangssignal (Si) modifizieren.

10. Verfahren nach Anspruch 7, wobei das besagte Verstärkersystem (100) Multiplexermittel (106) mit einer Vielzahl von Eingängen umfasst, wobei zumindest zwei der besagten Eingänge an einen Ausgang einer entsprechenden der besagten Verstärkerstufen (110_1, ..., 110_n, 110_n+1) angeschlossen sind, und wobei eine Steuerungseinheit (108) einen der besagten Eingänge der Multiplexermittel (106) für den Anschluss an einen Ausgang der Multiplexermittel (106) auswählt.

11. Verfahren nach einem der Ansprüche 7 bis 10, wobei eine Rückkopplungsschleife (104) vorgesehen ist, welche einen Abschnitt des Ausgangssignals (S2) des besagten Verstärkersystems (100) an Vorverzerrungsmittel (104c), welche ein Eingangssignal (S1) für das Verstärkersystem (100) in Abhängigkeit von dem besagten Abschnitt des Ausgangssignals (S2) des besagten Verstärkersystems (100) modifizieren, zurückkoppelt.

## Revendications

1. Système amplificateur (100) comprenant une pluralité d'étages d'amplification (110, 120), dans lequel chaque étage d'amplification (110, 120) comprend au moins une structure d'amplification (112) et des moyens de linéarisation (114) qui sont associés à ladite au moins une structure d'amplification (112) et qui sont configurés pour linéariser un signal de sortie (So) de ladite au moins une structure d'amplification (112) dudit étage d'amplification (110, 120), dans lequel lesdits étages d'amplification (110, 120) sont reliés en série l'un à l'autre, et dans lequel ledit système amplificateur (100) est configuré pour relier sélectivement un terminal de sortie (109) dudit système amplificateur (100) à une sortie d'un desdits étages d'amplification (110, 120) et pour désactiver ou pour régler sur un mode d'économie d'énergie des étages d'amplification suivants.

2. Système amplificateur (100) selon l'une des revendications précédentes, dans lequel ladite au moins une structure d'amplification (112) comprend un amplificateur unique (112a) ou une chaîne d'une pluralité d'amplificateurs (112a, 112b).

3. Système amplificateur (100) selon l'une des revendications précédentes, dans lequel lesdits moyens de linéarisation (114) sont configurés pour recevoir une partie d'un signal de sortie (So) de la structure d'amplification associée (112) et pour modifier un signal d'entrée (Si) pour ladite structure d'amplification (112) ou ledit signal de sortie (So) en fonction dudit signal d'entrée (Si).

4. Système amplificateur (100) selon l'une des revendications précédentes, dans lequel on prévoit une unité de commande (108) qui est configurée pour commander une désactivation desdits étages d'amplification suivants.

5. Système amplificateur (100) selon la revendication 1, dans lequel ledit système amplificateur (100) comprend des moyens de multiplexage (106) qui comprennent une pluralité d'entrées, dans lequel au moins deux desdites entrées sont reliées à une sortie d'un étage respectif desdits étages d'amplification (110, 120), et une unité de commande (108) qui est configurée pour sélectionner une desdites entrées des moyens de multiplexage (106) à relier à une sortie des moyens de multiplexage (106).

6. Système amplificateur (100) selon l'une des revendications précédentes, dans lequel on prévoit une boucle de rétroaction (104) qui couple en retour une partie du signal de sortie (S2) dudit système amplificateur (100) à des moyens de prédistorsion (104c) qui sont configurés pour modifier un signal d'entrée (S1) pour le système amplificateur (100) en fonction de ladite partie du signal de sortie (S2) dudit système amplificateur (100).

7. Procédé de fonctionnement d'un système amplificateur (100) comprenant une pluralité d'étages d'amplification (110, 120), dans lequel chaque étage d'amplification (110) comprend au moins une structure d'amplification (112) et des moyens de linéarisation (114) qui sont associés à ladite au moins une structure d'amplification (112) et qui sont configurés pour linéariser un signal de sortie (So) de ladite au moins une structure d'amplification (112) dudit étage d'amplification (110, 120), dans lequel un signal de sortie d'un premier desdits étages d'amplification (110, 120) est amplifié par un deuxième desdits étages d'amplification (110, 120), dans lequel lesdits étages d'amplification (110, 120) sont reliés en série l'un à l'autre, et dans lequel ledit système amplificateur (100) relie sélectivement un terminal de sortie (109) dudit système amplificateur (100) à une sortie d'un desdits étages d'amplification (110, 120) et désactive ou règle sur un mode d'économie d'énergie des étages d'amplification suivants.

8. Procédé selon la revendication 7, dans lequel ladite au moins une structure d'amplification (112) amplifie un signal d'entrée au moyen d'un amplificateur unique (112a) ou d'une chaîne d'une pluralité d'amplificateurs (112a, 112b).

9. Procédé selon l'une des revendications 7 et 8, dans lequel lesdits moyens de linéarisation (114) reçoivent une partie d'un signal de sortie (So) de sa structure d'amplification associée (112) et modifient un signal d'entrée (Si) pour ladite structure d'amplification (112) ou ledit signal de sortie (So) en fonction dudit signal d'entrée (Si).

10. Procédé selon la revendication 7, dans lequel ledit système amplificateur (100) comprend des moyens de multiplexage (106) qui comprennent une pluralité d'entrées, dans lequel au moins deux desdites entrées sont reliées à une sortie d'un étage respectif desdits étages d'amplification (110_1, .., 110_n, 110_n+1), et dans lequel une unité de commande (108) sélectionne une desdites entrées des moyens de multiplexage (106) à relier à une sortie des moyens de multiplexage (106).

11. Procédé selon l'une des revendications 7 à 10, dans lequel on prévoit une boucle de rétroaction (104) qui couple en retour une partie du signal de sortie (S2) dudit système amplificateur (100) à des moyens de prédistorsion (104c) qui modifient un signal d'entrée (S1) pour le système amplificateur (100) en fonction de ladite partie du signal de sortie (S2) dudit système amplificateur (100).
